# EUROPÄISCHE PATENTSCHRIFT

(11) **EP 2 304 479 B1**
(45) Veröffentlichungstag und Bekanntmachung des Hinweises auf die Patenterteilung: **19.07.2017**
(21) Anmeldenummer: 09776669.5
(22) Anmeldetag: 30.05.2009
(51) Int. Cl.: G02B 5/08, G21K 1/06, C23C 14/00

(54) **REFLEKTIVES OPTISCHES ELEMENT UND VERFAHREN ZU SEINER HERSTELLUNG**
REFLECTIVE OPTICAL ELEMENT AND METHOD FOR THE PRODUCTION THEREOF
ÉLÉMENT OPTIQUE RÉFLÉCHISSANT ET PROCÉDÉ POUR SA FABRICATION

(30) Priorität: 09.07.2008 DE 102008040265; 09.07.2008 US 79307 P
(43) Veröffentlichungstag der Anmeldung: 06.04.2011
(73) Patentinhaber: Carl Zeiss SMT GmbH, 73447 Oberkochen (DE)
(72) Erfinder: TSARFATI, Tim, NL-3583 HB Utrecht (NL); ZOETHOUT, Erwin, NL-3581 LK Utrecht (NL); LOUIS, Eric, NL-3402 ZH IJsselstein (NL); BIJKERK, Frederik, NL-3735 LW Bosch En Duin (NL)
(74) Vertreter: Werner & ten Brink
(86) Internationale Anmeldenummer: PCT/EP2009/003905
(87) Internationale Veröffentlichungsnummer: WO 2010/003487

(56) Entgegenhaltungen:
- WO-A-93/09545
- WO-A-2004/023495
- WO-A-2006/066563
- WO-A-2007/090364
- WO-A-2008/095663
- WO-A2-2009/085094
- US-A- 5 310 603
- US-A1- 2004 121 134
- US-B1- 6 396 900

## Beschreibung

### Gebiet der Erfindung

Die vorliegende Erfindung bezieht sich auf reflektive optische Elemente für eine Arbeitswellenlänge im Bereich von 5 nm bis 12 nm, die ein Viellagensystem aus mindestens zwei alternierenden Materialien mit unterschiedlichem Realteil des Brechungsindex bei der Arbeitswellenlänge aufweisen, und deren Verwendung. Ferner bezieht sich die Erfindung auf ein Projektionssystem und ein Beleuchtungssystem sowie auf eine EUV-Lithographievorrichtung mit mindestens einem derartigen reflektiven optischen Element. Außerdem bezieht sich die Erfindung auf ein Verfahren zur Herstellung derartiger reflektiver optischer Elemente.

### Hintergrund und Stand der Technik

In EUV-Lithographievorrichtungen werden zur Lithographie von Halbleiterbauelementen reflektive optische Elemente für den extremen ultravioletten (EUV) bzw. weichen Röntgenwellenlängenbereich (z.B. Wellenlängen zwischen ca. 5 nm und 20 nm) wie etwa Photomasken oder Viellagenspiegel eingesetzt. Da EUV-Lithographievorrichtungen in der Regel mehrere reflektive optische Elemente aufweisen, müssen diese eine möglichst hohe Reflektivität aufweisen, um eine hinreichend hohe Gesamtreflektivität sicherzustellen. Da üblicherweise in einer EUV-Lithographievorrichtung mehrere reflektive optische Elemente hintereinander angeordnet sind, wirken sich auch schon geringere Verschlechterungen der Reflektivität bei jedem einzelnen reflektiven optischen Element in größerem Maße auf die Gesamtreflektivität innerhalb der EUV-Lithographievorrichtung aus.

Reflektive optische Elemente für den EUV- und weichen Wellenlängenbereich weisen in der Regel Viellagensysteme auf. Dabei handelt es sich um alternierend aufgebrachte Lagen eines Materials mit höherem Realteil des Brechungsindex bei der Arbeitswellenlänge (auch Spacer genannt) und eines Materials mit niedrigerem Realteil des Brechungsindex bei der Arbeitswellenlänge (auch Absorber genannte), wobei ein Absorber-Spacer-Paar einen Stapel bildet. Dadurch wird in gewisser Weise ein Kristall simuliert, dessen Netzebenen den Absorberlagen entsprechen, an denen Bragg-Reflexion stattfindet. Die Dicken der einzelnen Lagen wie auch der sich wiederholenden Stapel können über das gesamte Viellagensystem konstant sein oder auch variieren, je nach dem, welches Reflexionsprofil erreicht werden soll.

Insbesondere für Arbeitswellenlängen im Wellenlängenbereich zwischen 5 nm bis 12 nm sind nicht nur die mit Viellagensystemen theoretisch erreichbare maximale Reflektivität geringer als im Wellenlängenbereich von etwa 12 nm bis 20 nm. Besonders auch die Bandbreite der reflektierten Strahlung ist wesentlich geringer. Problematisch ist zusätzlich, dass bei den bisher häufig eingesetzten Materialien Lanthan als Absorber und Bor oder Borkarbid als Spacer schon bei Raumtemperatur insbesondere an der Grenzfläche Bor oder Borkarbid zu Lanthan eine starke Durchmischung der einzelnen Lagen zu einer Mischschicht aus z.B. Lanthanborid stattfindet. Dies führt zu einer signifikanten Verringerung sowohl der tatsächlichen maximalen Reflektivität als auch der reflektierten Bandbreite. Da üblicherweise in einer EUV-Lithographievorrichtung mehrere reflektive optische Elemente hintereinander angeordnet sind, wirken sich auch schon geringere Verschlechterungen der maximalen Reflektivität und Bandbreite jedes einzelnen reflektiven optischen Elements über die Lebensdauer in größerem Maße auf die Gesamtreflektivität aus.

Für einen Arbeitswellenlängenbereich von 12,5 nm bis 15 nm ist aus der US 2004/121134 A1 bekannt, bei Molybdän-Silizium-Viellagensystemen Diffusionsbarrierelagen aus u.a. Molybdänkarbid vorzusehen, und aus der WO 2007/090364 A2 in Molybdän-Silizium-Viellagesystemen Molybdän als Absorbermaterial durch Molybdännitrid zu ersetzen.

### Zusammenfassung der Erfindung

Es ist eine Aufgabe der vorliegenden Erfindung, reflektive optische Elemente für Arbeitswellenlängen im weichen Röntgen- und extremen ultravioletten Wellenlängenbereich zur Verfügung zu stellen, die im tatsächlichen Einsatz über eine längere Zeit hinreichend hohe maximale Reflektivitäten und reflektierte Bandbreiten gewährleisten.

In einem ersten Aspekt der Erfindung wird diese Aufgabe durch ein reflektives optisches Element für eine Arbeitswellenlänge im Bereich von 5 nm bis 12 nm gelöst, das ein Viellagensystem aus mindestens zwei alternierenden Materialien mit unterschiedlichem Realteil des Brechungsindex bei der Arbeitswellenlänge aufweist, bei dem an mindestens einem Übergang vom Material mit größerem Realteil des Brechungsindex zum Material mit kleinerem Realteil des Berechungsindex oder vom Material mit kleinerem Realteil des Berechungsindex zum Material mit größerem Realteil des Brechungsindex eine weitere Lage aus einem Nitrid oder Karbid des Material mit kleinerem Realteil des Brechungsindex angeordnet ist, wobei es sich bei dem Material mit kleinerem Realteil des Brechungsindex um Lanthan, Thorium oder Uran handelt.

Es hat sich herausgestellt, dass das Vorsehen von Zwischenschichten aus Nitriden oder von Karbiden, speziell in Viellagensystemen mit Lanthan, Thorium oder Uran als Absorber, zu thermisch und thermodynamisch stabileren Viellagensystemen führt, bei denen auch über längere Zeiten oder bei erhöhten Temperaturen keine wesentliche Vermischung einzelner Lagen stattfindet. Dadurch bleiben die optischen Eigenschaften wie maximale Reflektivität und reflektierte Bandbreite von reflektiven optischen Elementen, die solche Viellagensysteme aufweisen, über die gesamte Lebensdauer in einem verlässlichen Rahmen. Erstaunlicherweise hat sich herausgestellt, dass das Einfügen von Zwischenschichten aus Nitrid oder Karbid zu nur geringen Einbußen bei der maximalen Reflektivität oder der Bandbreite verglichen mit Viellagensystemen ohne diese Zwischenschichten führt. Insbesondere sind diese Einbußen geringer als die Einbußen, die man aufgrund starker Vermischung der Absorber und Spacerlagen in Kauf nehmen muss. Bei manchen Viellagensystemen wird durch das Einfügen der Zwischenschichten sogar eine leichte Verbesserung der optischen Eigenschaften des resultierenden reflektiven optischen Elements erreicht, d.h. der maximalen Reflektivität und/oder der reflektierten Bandbreite.

In einem zweiten Aspekt der Erfindung wird diese Aufgabe durch ein reflektives optisches Element für eine Arbeitswellenlänge im Bereich von 5 nm bis 12 nm gelöst, das ein Viellagensystem aus mindestens zwei alternierenden Materialien mit unterschiedlichem Realteil des Brechungsindex bei der Arbeitswellenlänge aufweist, bei dem das Material mit kleinerem Realteil des Brechungsindex ein Nitrid oder Karbid ist, wobei es sich bei dem Material mit kleinerem Realteil des Brechungsindex um Lanthannitrid, Thoriumnitrid, Lanthankarbid oder Thoriumkarbid handelt.

Es hat sich herausgestellt, dass sogar das Ersetzen des Absorbers durch sein Nitrid oder sein Karbid, insbesondere im Falle von Thorium und Lanthan als Absorber, nur zu Einbußen bei maximaler Reflektivität und reflektierter Bandbreite führt die geringer sind als die Einbußen aufgrund der Durchmischung der Absorber- und Spacerlagen, insbesondere bei Viellagensystemen mit Thorium oder Lanthan als Absorbermaterial und Bor oder Borkarbid als Spacermaterial. Teilweise werden die maximale Reflektivität und die reflektierte Bandbreite sogar erhöht, wobei gleichzeitig die thermische und thermodynamische Stabilität erhöht wird.

Es gibt ein reflektives optisches Element für eine Arbeitswellenlänge im Bereich von 5 nm bis 12 nm, das ein Viellagensystem aus mindestens zwei alternierenden Materialien mit unterschiedlichem Realteil des Brechungsindex bei der Arbeitswellenlänge aufweist, bei dem das Material mit kleinerem Realteil des Brechungsindex Thorium, Uran oder Barium ist.

Es hat sich herausgestellt, dass Viellagensysteme auf der Basis von Thorium als Absorber im Vergleich zu Viellagensystemen auf der Basis von Lanthan als Absorber zwar geringere maximale Reflektivitäten bei Arbeitswellenlängen im Bereich von ca. 5 nm bis 12 nm aufweisen, dies aber im wesentlichen durch breitere Bandbreiten an reflektierter Strahlung kompensiert wird.

Die genannten reflektiven optischen Elemente zur Reflexion von Strahlung im Wellenlängenbereich von 5 nm bis 12 nm lassen sich bei einer Betriebstemperatur von 20°C bis 600°C verwenden.

Man kann die genannten reflektiven optischen Elemente als Kollektor von Strahlung im Wellenlängenbereich von 5 nm bis 12 nm in einer EUV-Lithographievorrichtung verwenden.

In weiteren Aspekten der Erfindung wird diese Aufgabe durch ein Projektionssystem, insbesondere für eine EUV-Lithographievorrichtung, mit mindestens einem der zuvor genannten reflektiven optischen Elemente, durch ein Beleuchtungssystem, insbesondere für eine EUV-Lithographievorrichtung, mit mindestens einem der zuvor genannten reflektiven optischen Elemente, durch ein Strahlformungssystem, insbesondere für eine EUV-Lithographievorrichtung, mit mindestens einem der zuvor genannten reflektiven optischen Elemente, sowie durch eine EUV-Lithographievorrichtung mit mindestens einem der zuvor genannten reflektiven optischen Elemente gelöst.

Man kann die zuvor genannten reflektiven optischen Elemente herstellen, indem die Lagen mindestens eines Materials plasmaunterstützt aufgebracht werden.

Man kann zunächst eine Lage des Materials mit kleinerem Realteil des Brechungsindex aufbringen, die anschließend einem stickstoff- oder kohlenstoffhaltigen Plasma ausgesetzt wird.

Es ist möglich, das Aufbringen einer Lage des Materials mit kleinerem Realteil des Brechungsindex zumindest teilweise mit Unterstützung eines stickstoff- oder kohlenstoffhaltigen Plasmas durchzuführen.

Vorteilhafte Ausgestaltungen finden sich in den abhängigen Ansprüchen.

### Kurze Beschreibung der Figuren

Die vorliegende Erfindung soll unter Bezugnahme auf ein bevorzugtes Ausführungsbeispiel näher erläutert werden. Dazu zeigen
- Figur 1: schematisch eine Ausführungsform einer EUV-Lithographievorrichtung;
- Figuren 2a-d: schematisch den Aufbau eines reflektiven optischen Elements und verschiedener Viellagensysteme;
- Figur 3: die Reflektivität in Abhängigkeit der Wellenlänge für reflektive optische Elemente mit Viellagensystemen mit Thorium, Lanthan oder Uran als Absorber;
- Figur 4a: die Reflektivität in Abhängigkeit der Wellenlänge für reflektive optische Elemente mit Lanthan/Bor-Viellagensystemen mit unterschiedlichen Dicken der Durchmischungsschichten;
- Figur 4b: die Reflektivität in Abhängigkeit der Wellenlänge für reflektive optische Elemente mit einem Lanthan/Borkarbid-Viellagensystem mit einer Durchmischungsschicht sowie mit einer Lanthannitridzwischenschicht;
- Figur 4c: die Reflektivität in Abhängigkeit der Wellenlänge für reflektive optische Elemente mit einem Uran/Borkarbid-Viellagensystem sowie mit einem Uran/Urannitrid/Borkarbid-Viellagensystem;
- Figuren 5a,b: die Reflektivität in Abhängigkeit der Wellenlänge für reflektive optische Elemente mit Viellagensystemen mit Thorium als Absorber und Thoriumnitridzwischenschichten;
- Figuren 6a,b: die Reflektivität in Abhängigkeit der Wellenlänge für reflektive optische Elemente mit Viellagensystemen mit Thorium als Absorber und Thoriumkarbidzwischenschichten;
- Figuren 7a,b: die Reflektivität in Abhängigkeit der Wellenlänge für reflektive optische Elemente mit Viellagensystemen mit Lanthan als Absorber und Lanthannitridzwischenschichten;
- Figuren 8a,b: die Reflektivität in Abhängigkeit der Wellenlänge für reflektive optische Elemente mit Viellagensystemen mit Lanthan als Absorber und Lanthankarbidzwischenschichten;
- Figur 9: ein Flussdiagramm zu einer ersten Ausführungsform des Verfahrens zum Herstellen von reflektiven optischen Elementen; und
- Figur 10: ein Flussdiagramm zu einer zweiten Ausführungsform des Verfahrens zum Herstellen von reflektiven optischen Elementen.

### Ausführliche Beschreibung der Erfindung

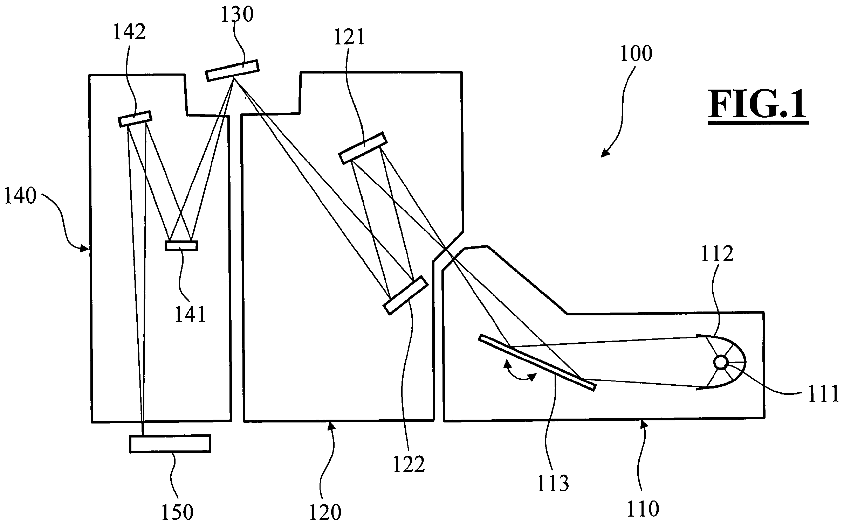

In Figur 1 ist schematisch eine EUV-Lithographievorrichtung 100 dargestellt. Wesentliche Komponenten sind das Strahlformungssystem 110, das Beleuchtungssystem 120, die Photomaske 130 und das Projektionssystem 140.

Als Strahlungsquelle 111 kann beispielsweise eine Plasmaquelle oder auch ein Synchrotron dienen. Insbesondere für den Wellenlängenbereich von 5 nm bis 12 nm bieten sich auch Röntgenlaser (X-FEL) als Strahlungsquelle an. Die austretende Strahlung wird zunächst in einem Kollektorspiegel 112 gebündelt. Außerdem wird mit Hilfe eines Monochromators 113 durch Variation des Einfallswinkels die gewünschte Betriebswellenlänge herausgefiltert. Im genannten Wellenlängenbereich sind der Kollektorspiegel 112 und der Monochromator 113 üblicherweise als reflektive optische Elemente ausgebildet, die, um eine Reflexion der Strahlung der Arbeitswellenlänge zu erreichen, ein Viellagensystem aus mindestens zwei alternierenden Materialien mit unterschiedlichem Realteil des Brechungsindex bei der Arbeitswellenlänge aufweisen. Kollektorspiegel sind häufig schalenförmig ausgebildete reflektive optische Elemente, um einen fokussierenden bzw. kollimierenden Effekt zu erreichen. Sowohl der Kollektorspiegel 112 als auch der Monochromator 113 können dabei als reflektive optische Elemente auf der Basis von Lanthan, Thorium, Uran oder Barium ausgestaltet sein, wie sie später im Detail erläutert werden. Da Kollektorspiegel im Strahlengang sehr nah an der Strahlungsquelle angeordnet sind, sind sie einer hohen Wärmelast ausgesetzt. Daher sind Kollektorspiegel mit einem Viellagensystem, das Lanthan, Thorium, Uran oder Barium aufweist, besonders geeignet.

Der im Strahlformungssystem 110 in Hinblick auf Wellenlänge und räumliche Verteilung aufbereitete Betriebsstrahl wird dann in das Beleuchtungssystem 120 eingeführt. Im in Figur 1 dargestellten Beispiel weist das Beleuchtungssystem 120 zwei Spiegel 121, 122 auf, die im vorliegenden Beispiel als Viellagenspiegel ausgestaltet sind. Die Spiegel 121, 122 leiten den Strahl auf die Photomaske 130, die die Struktur aufweist, die auf den Wafer 150 abgebildet werden soll. Bei der Photomaske 130 handelt es sich ebenfalls um ein reflektives optisches Element für den EUV- und weichen Wellenlängenbereich, das je nach Herstellungsprozess ausgewechselt wird. Mit Hilfe des Projektionssystems 140 wird der von der Photomaske 130 reflektierte Strahl auf den Wafer 150 projiziert und dadurch die Struktur der Photomaske auf ihn abgebildet. Das Projektionssystem 140 weist im dargestellten Beispiel zwei Spiegel 141, 142 auf, die im vorliegenden Beispiel ebenfalls als Viellagenspiegel ausgestaltet sind. Es sei darauf hingewiesen, dass sowohl das Projektionssystem 140 als auch das Beleuchtungssystem 120 ebenso jeweils nur einen oder auch drei, vier, fünf und mehr Spiegel aufweisen können.

Im in Figur 1 dargestellten Beispiel sind alle Spiegel 121, 122, 141, 142 als reflektive optische Elemente auf der Basis von Lanthan, Thorium, Uran oder Barium ausgestaltet, wie sie später im Detail erläutert werden. Optional kann es sich auch bei der Photomaske 130 um ein derartiges reflektives optisches Element handeln.

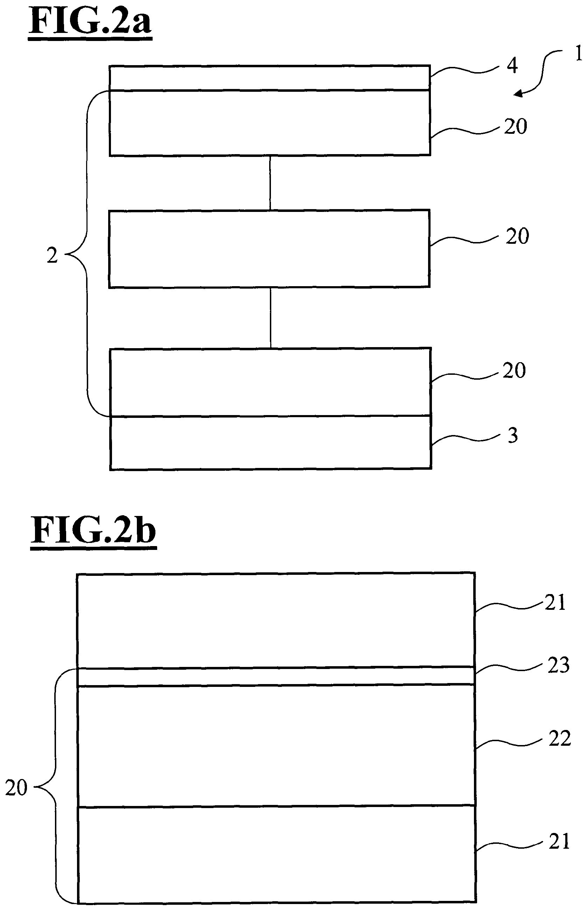

Figuren 2a-d zeigen beispielhaft ein reflektives optisches Element 1 für den extremen ultravioletten und weichen Röntgenwellenlängenbereich, insbesondere zur Verwendung in EUV-Lithographievorrichtungen, z.B. als Spiegel des Projektions- oder Beleuchtungssystems oder auch als Photomaske, Kollektorspiegel oder Monochromator. Figur 2a zeigt schematisch die übergeordnete Struktur des Viellagensystems 2. Das Viellagensystem 2 ist im vorliegenden Beispiel durch sukzessives Beschichten eines Substrats 3 mit unterschiedlichen Materialien mit unterschiedlichen komplexen Brechungsindizes hergestellt worden. Außerdem wurde auf das Viellagensystem 2 zusätzlich eine Schutzschicht 4 zum Schutz vor äußeren Einflüssen wie Kontamination aufgebracht, die aus mehreren unterschiedlichen Materiallagen aufgebaut sein kann.

Das Viellagensystem 2 besteht im Wesentlichen aus sich vielfach wiederholenden Stapeln 20, deren Struktur für verschiedene bevorzugte Ausführungsformen schematisch in den Figuren 2b-d dargestellt ist. Die wesentlichen Lagen eines Stapel 20, die insbesondere durch die vielfache Wiederholung der Stapel 20 zu hinreichend hoher Reflexion bei einer Arbeitswellenlänge führen, sind die so genannten Absorberlagen 22, 22' aus Material mit einem niedrigeren Realteil des Brechungsindex und die so genannten Spacerlagen 21 aus einem Material mit einem höheren Realteil des Brechungsindex. Dadurch wird gewissermaßen ein Kristall simuliert, wobei die Absorberlagen 22, 22' den Netzebenen innerhalb des Kristalls entsprechen, die einen durch die jeweiligen Spacerlagen 21 definierten Abstand zueinander haben und an denen Reflexion von einfallender EUV- bzw. weicher Röntgenstrahlung stattfindet. Die Dicken der Lagen werden derart gewählt, dass bei einer bestimmten Arbeitswellenlänge die an jeder Absorberlage 22, 22' reflektierte Strahlung sich konstruktiv überlagert, um somit eine hohe Reflektivität des reflektiven optischen Elements zu erreichen. Es sei darauf hingewiesen, dass die Dicken der einzelnen Lagen 21, 22, 22', 23, 24 wie auch der sich wiederholenden Stapel 20 über das gesamte Viellagensystem konstant sein oder auch variieren können, je nach dem, welches Reflexionsprofil erreicht werden soll. Insbesondere können Viellagensysteme für bestimmte Wellenlängen optimiert werden, bei denen die maximale Reflektivität und/oder die reflektierte Bandbreite größer als bei anderen, benachbarten Wellenlängen ist. Bei Strahlung dieser Wellenlänge wird das entsprechende reflektive optische Element 1 z.B. bei der EUV-Lithographie eingesetzt, weshalb diese Wellenlänge, für die das reflektive optische Element 1 optimiert wurde, auch Arbeitswellenlänge genannt wird.

Im Gegensatz zu Viellagensystemen für Arbeitswellenlängen im Bereich von 12 nm bis 20 nm, bei denen oft mit Molybdän als Absorbermaterial und mit Silizium als Spacermaterial gearbeitet wird, sind die Anforderungen an Viellagensysteme für Arbeitswellenlängen im Bereich von 5 nm bis 12 nm strenger, insbesondere zu kürzeren Wellenlängen hin. Reichen bei Molybdän/Silizium-Viellagensystemen beispielsweise 50 Stapel aus, um eine maximale Reflektivität von deutlich über 70% zu erhalten, benötigt man z.B. bei Viellagensystemen mit Lanthan, Thorium, Uran oder Barium als Absorber und mit Bor oder Borkarbid für kürzere Arbeitswellenlängen etwa 200 Stapel, um eine Reflektivität von etwa 50% oder mehr zu erreichen. Erschwerend kommt hinzu, dass dabei die Halbwertsbreite der Reflektivitätskurve, die ein Maß für die reflektierte Bandbreite ist, nur etwa 10% der Halbwertsbreite der Reflektivitätskurven von Molybdän/Silizium-Viellagensystemen beträgt. Dabei muss man zusätzlich berücksichtigen, dass bei realen Viellagensystemen besonders an den Grenzflächen von Spacer auf Absorber eine Durchmischung mit Bildung einer zusätzlichen Schicht stattfindet, die den Kontrast zwischen den Spacer- und Absorberlagen zum Teil deutlich verschlechtern kann. Dies führt zu noch geringeren maximalen Reflektivitäten und Bandbreiten.

Um der Verschlechterung der optischen Eigenschaften entgegenzuwirken, wird entsprechend dem in Figur 2b dargestellten Beispiel vorgeschlagen, am Übergang von Absorber 22 zu Spacer 21 eine zusätzliche Schicht 23 aus einem Nitrid oder Karbid des Absorbermaterials vorzusehen. Nitride und Karbide des Absorbermaterials haben den Vorteil, thermodynamisch stabiler zu sein als die Mischschichten, die sich aus Absorber- und Spacermaterial bilden. Ihre Dicke bleibt daher über längere Zeiträume als bei den Mischschichten konstant, so dass der Kontrast zwischen den Spacer- und Absorberlagen im Wesentlichen konstant bleibt. Auch ihre thermische Stabilität ist höher. Bei besonders dünnen Nitrid- bzw. Karbidschichten 23 lässt sich der Kontrast gegenüber Systemen ohne diese Zwischenschicht sogar leicht erhöhen. Die Karbid- oder die Nitridlage 23 weist bevorzugt eine Dicke von maximal 1 nm, vorteilhaft bis zu 0,5 nm, bevorzugt bis zu 0,4 nm, besonders bevorzugt bis zu 0,3 nm auf. Vorteilhafterweise wird die Karbid- bzw. Nitridschicht 23 als selbstterminierende Schicht aufgebracht. In solchen Fällen kann man erreichen, dass die Karbid- bzw. Nitridschicht 23 im Wesentlichen als Monolage betrachtet werden kann. Die Zwischenschicht aus Nitrid oder Karbid hat insbesondere beim Übergang von Absorber 22 zum Spacer 21 eine besonders deutliche kontrasterhöhende Wirkung.

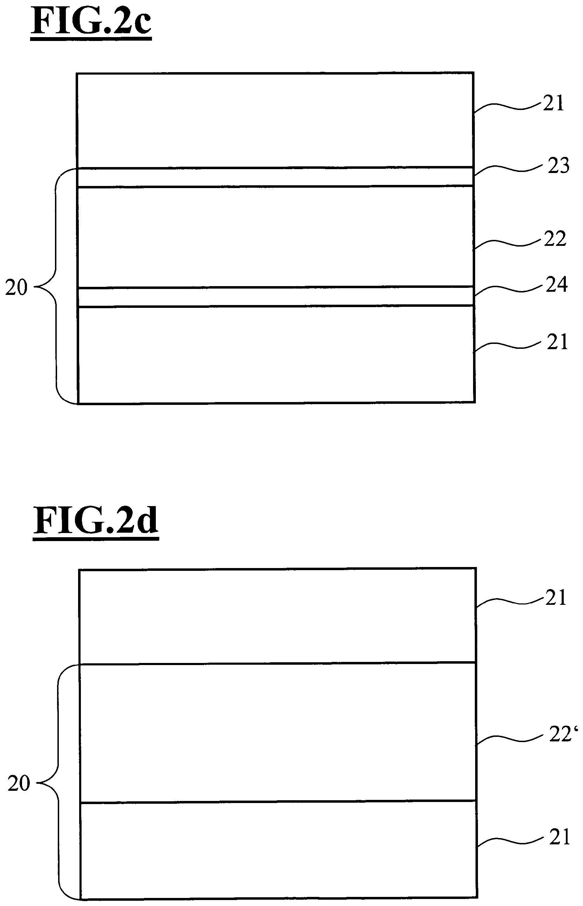

Im vorliegenden, in Figur 2c dargestellten Beispiel sind sowohl am Übergang von Absorber 22 zu Spacer 21 eine zusätzliche Schicht 23 aus einem Nitrid oder Karbid des Absorbermaterials als auch am Übergang von Spacer 21 zu Absorber 22 eine zusätzliche Schicht 24 aus einem Nitrid oder Karbid des Spacermaterials vorgesehen, um die thermodynamische und thermische Stabilität des Viellagensystems zu erhöhen.

Im in Figur 2d dargestellten Beispiel wurde statt einer zusätzliche Nitrid- oder Karbidschicht die Nitrid- bzw. Karbidschicht eines geeigneten Absorbermaterials als Absorberlage 22' eingesetzt, was nicht nur zu thermisch und thermodynamisch relativ stabilen Viellagensystemen führt, sondern auch befriedigende maximale Reflektivitäten und Bandbreiten gewährleistet. Alternativ zu den Nitriden und Karbiden können auch Thorium, Uran oder Barium als Material für die Absorberlage 22' mit positivem Effekt eingesetzt werden.

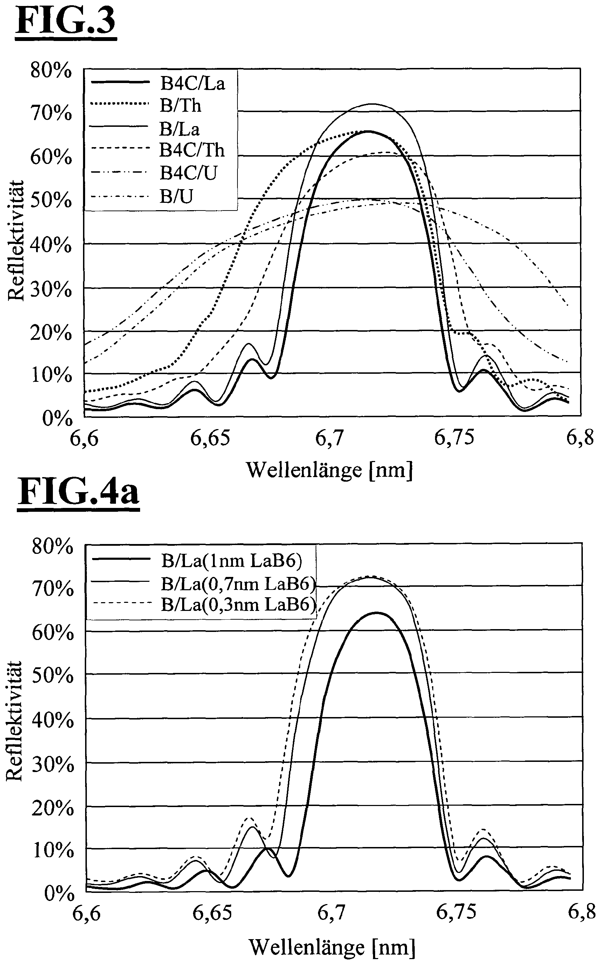

In Figur 3 ist exemplarisch die Reflektivität in Abhängigkeit von Wellenlänge für die Viellagensysteme Thorium/Bor, Thorium/Borkarbid, Lanthan/Bor, Lanthan/Borkarbid, Uran/Bor und Uran/Borkarbid dargestellt. Dabei handelt es sich um Systeme mit jeweils 200 Stapeln. Die Dicke eines Stapels liegt im vorliegenden Beispiel bei 3,4 nm. Die Spacerlagendicke liegt bei etwa 1,7 nm, die Absorberlagendicke bei etwa 1,4 nm. Zusätzlich hat sich eine etwa 0,3 nm dicke Mischschicht aus Thoriumborid bzw. Lanthanborid bzw. Uranborid gebildet. Die Arbeitswellenlänge liegt für alle vier Systeme im Bereich zwischen 6,70 nm und 6,75 nm. Insgesamt weisen die Viellagensysteme mit Thorium als Absorbermaterial eine geringere maximale Reflektivität als die Viellagensysteme mit Lanthan als Absorbermaterial auf. Dies wird aber im Hinblick auf die Gesamtreflektivität durch die deutlich größere Bandbreite der reflektierten Strahlung kompensiert. Dieser Effekt ist noch deutlicher bei Uran als Absorbermaterial zu erkennen. Zu beobachten ist außerdem, dass die Systeme mit Borkarbid als Spacermaterial eine geringere Reflektivität in Bezug auf maximale Reflektivität und Bandbreite aufweisen als die Systeme mit Bor als Spacermaterial. Letztere haben dagegen den Nachteil thermodynamisch etwas instabiler zu sein, so dass deren Lebensdauer etwas geringer ist.
Der Effekt der mit der Zeit immer stärkeren Vermischung des Absorber- und Spacermaterials ist am Beispiel eines Lanthan/Bor-Viellagensystems in Figur 4a dargestellt. Ausgehend von dem bereits in Figur 3 erläuterten Lanthan/Bor-Viellagensystem ist hier zusätzlich die Reflektivität für eine Dicke der Mischschicht von 0,7 nm und von 1 nm dargestellt. Während bei einer Dicke der Mischschicht aus Lanthanborid von 0,7 nm die maximale Reflektivität noch nicht merkbar abnimmt, muss schon eine deutliche Abnahme der Bandbreite hingenommen werde. Bei einer Mischschichtdicke von 1 nm ist die Abnahme von maximaler Reflektivität wie auch der Bandbreite bereits gravierend.

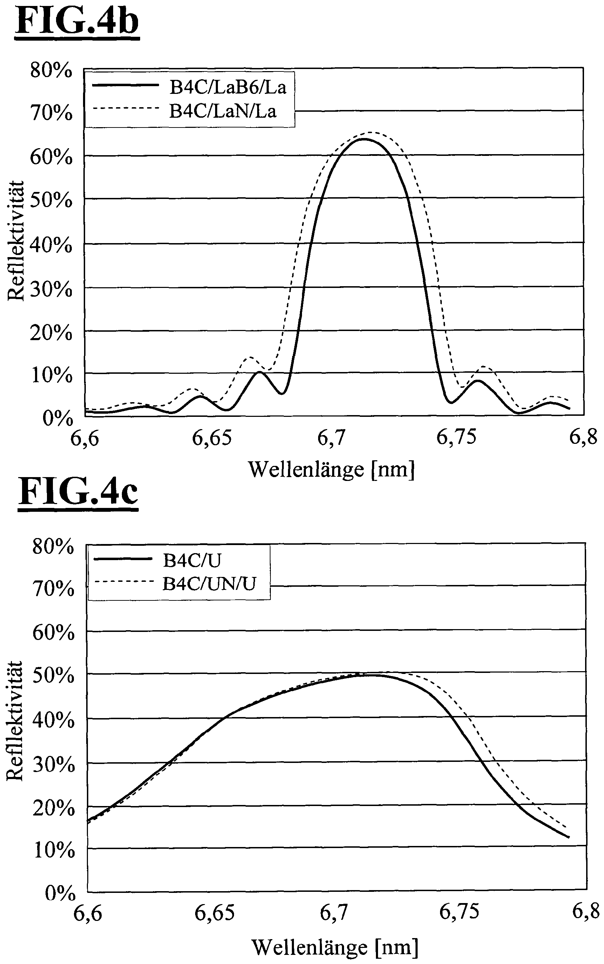

Um die thermische Stabilität der Viellagensysteme für den Wellenlängenbereich von etwa 5 nm bis 12 nm zu erhöhen, wird z.B. entsprechend dem in Figur 4b dargestellten Beispiel eine Lanthannitridschicht zwischen den Absorberlagen aus Lanthan und den Spacerlagen aus Borkarbid vorgesehen. Beide Systeme weisen zur besseren Vergleichbarkeit mit den übrigen Beispielen erneut 200 Stapel einer Dicke von 3,4 nm auf. Sowohl die Lanthannitridschicht als auch die Lanthanboridschicht haben eine Dicke von 0,3 nm. Das Viellagensystem mit der Lanthannitridschicht ist nicht nur thermisch stabiler, sondern führt zu einer um ca. 1,3% höheren maximalen Reflektivität und einer um sogar ca. 20% größeren Halbwertsbreite verglichen mit dem Lanthan/Bor-Viellagensystem, bei dem sich bereits eine 0,3 nm dicke Mischschicht aus Lanthanborid gebildet hat.

In Figur 4c ist der positive Effekt einer Absorbernitridschicht zwischen Absorber und Spacer am Beispiel eine Uran/Borkarbid-Viellagensystems dargestellt. Die Urannitridschicht, die im hier dargestellten Beispiel in Wachstumsrichtung der Lagen auf einer Uran- und unter einer Borkarbidlage angeordnet ist, führt sowohl zu einer Erhöhung der maximalen Reflektivität als auch zu einer höheren Halbwertszeit. Zur besseren Vergleichbarkeit beträgt wie in den vorangegangenen Beispielen die Stapeldicke 3,4 nm und hat die Nitridschicht eine Dicke von 0,7 nm.

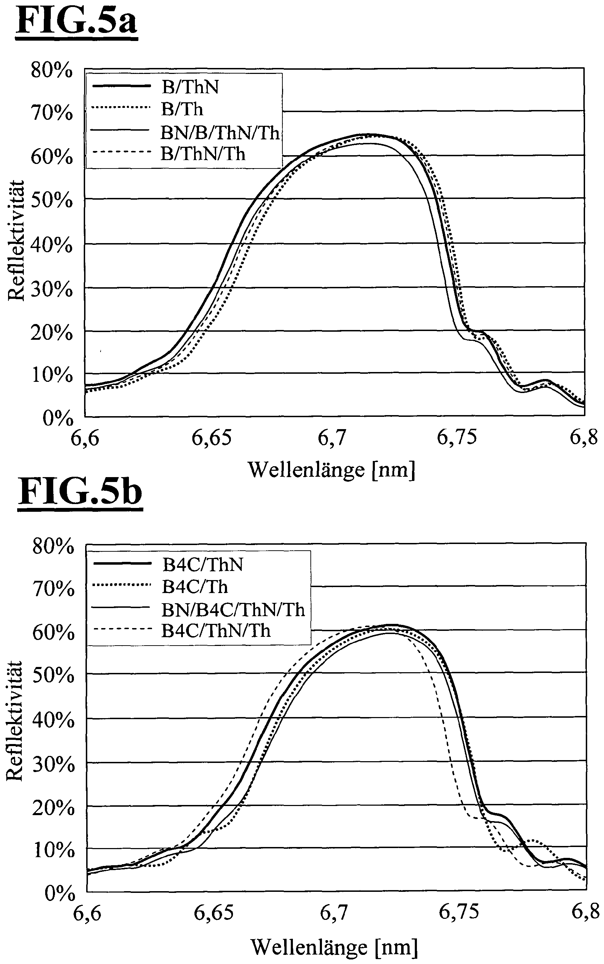

In den Figuren 5a bis 8b sind die Reflektivitätskurven in Abhängigkeit der Wellenlänge für diverse Beispiele von Viellagensystemen mit Thorium oder Lanthan als Absorbermaterial und Bor oder Borkarbid als Spacermaterial dargestellt. Alle Systeme sind für eine Arbeitswellenlänge im Bereich von 6,70 nm bis 6,75 nm optimiert worden. Sie weisen 200 Stapel einer Dicke von 3,4 nm, bei denen die Spacerlage 1,7 nm dick ist und die Absorberlage 1,4 nm. Die Lagen aus einem Nitrid oder Karbid des Absorbermaterials haben eine Dicke von 0,3 nm. In den Fällen, in denen auch eine Lage aus einem Nitrid oder Karbid des Spacermaterials vorgesehen ist, hat diese ebenfalls eine Dicke von 0,3 nm und die Spacerlage entsprechend eine Dicke von 1,4 nm. Bei den Systemen Thorium/Bor, Thorium/Borkarbid, Lanthan/Bor, Lanthan/Borkarbid ist eine Mischschicht von etwa 0,3nm an den Grenzflächen von Spacer auf Absorber vorhanden. Bei den Systemen mit einem Nitrid oder Karbid als Absorbermaterial hat die Absorberlage eine Dicke von 1,7 nm. An der Grenzfläche Absorber auf Spacer ist diese Mischschicht weniger ausgeprägt. Denn in vielen Fällen und bei den meisten Beschichtungsmethoden sind die Materialien, mit der die zu beschichtende Oberfläche beaufschlagt werden, um eine Spacerlage aufzubringen, reaktiver als die zum Aufbringen einer Absorberlage.

Es sei darauf hingewiesen, dass die hier angegeben Zahlenwerte nur beispielhaft zu verstehen sind und sowohl die Dicken der einzelnen Lagen wie auch die Stapelanzahl beliebig variiert werden können, um eine Lage der Arbeitswellenlänge im Wellenlängenbereich von etwas 5 nm bis 12 nm und ein gewünschtes Reflexionsprofil, z.B. durch Variation der Lagendicken bzw. Stapeldicken, zu erreichen.

In Figur 5a sind die Reflektivitätskurven für die Systeme Thorium/Bor alleine oder mit einer oder zwei zusätzlichen Nitridschichten und das System Thoriumnitrid/Bor dargestellt. Das System mit zwei Nitridschichten hat die geringste maximale Reflektivität und eine geringfügig geringere Bandbreite. Dafür zeichnet sie sich durch eine hohe thermodynamische Stabilität aus. Sowohl das Vorsehen einer Thoriumnitridzwischenlage als auch von Thoriumnitrid als Absorbermaterial führt zu leicht höheren maximalen Reflektivitäten und größeren Bandbreiten im Vergleich zu Thorium/Bor, wobei dieser Effekt bei Thoriumnitrid als Absorbermaterial besonders ausgeprägt ist. Dies lässt sich im Wesentlichen auch für die entsprechenden Systeme mit Borkarbid als Spacermaterial, wie in Figur 5b dargestellt, erkennen.

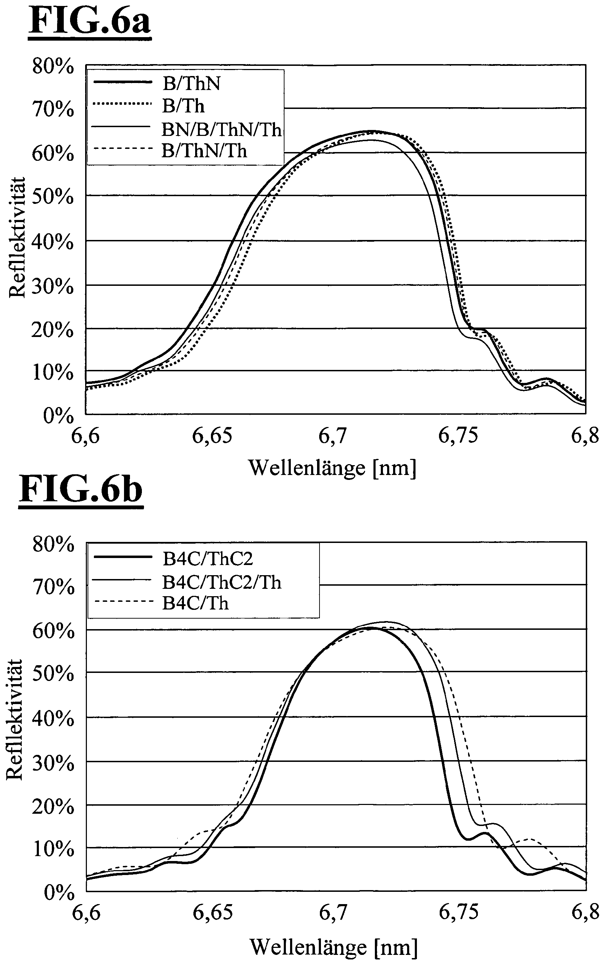

In den Figuren 6a, b sind die entsprechenden Thorium/Bor- und Thorium/Borkarbid-Systeme mit Karbid- statt Nitridschichten dargestellt. Hier führt das Einführen der Karbidschichten in allen Systemen zu einer leichten Verschlechterung der Reflektivität verglichen mit den unveränderten Thorium/Bor- oder Thorium/Borkarbid-Systemen, die gestrichelt dargestellt sind. Allerdings führt oder führen die Karbidschicht oder - schichten zu einer verbesserten thermischen und thermodynamischen Stabilität, so dass die Lebensdauer der entsprechenden reflektiven optischen Elemente bei im Wesentlichen gleich bleibender Reflektivität länger ist.

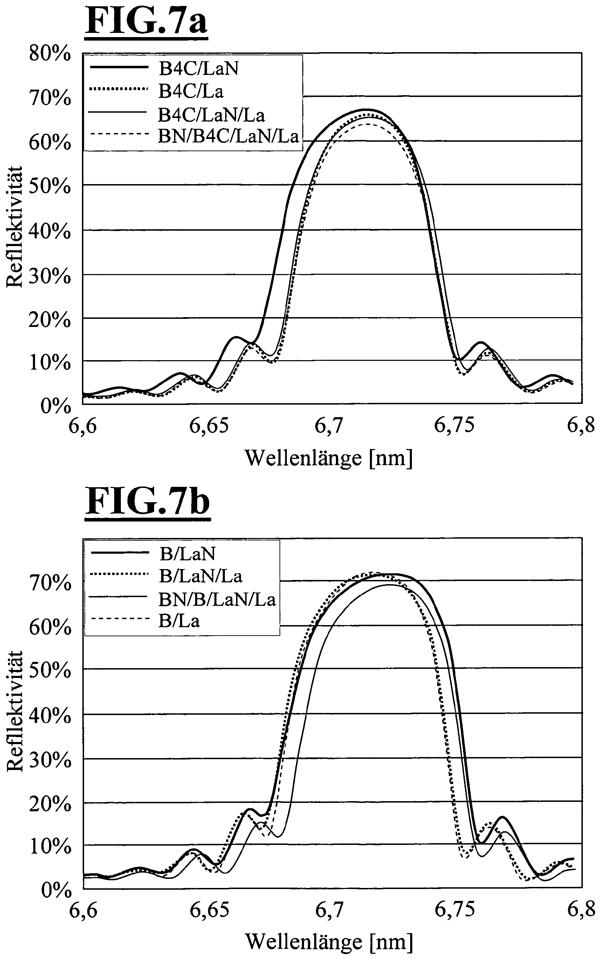

In Figur 7a sind die Reflektivitätskurven für die Systeme Lanthan/Borkarbid alleine oder mit einer oder zwei zusätzlichen Nitridschichten und das System Lanthan/Borkarbid dargestellt. Das System mit zwei Nitridschichten hat die geringste maximale Reflektivität und eine geringfügig geringere Bandbreite. Dafür zeichnet es sich durch eine hohe thermische und thermodynamische Stabilität aus. Sowohl das Vorsehen eine Lanthannitridzwischenlage als auch Lanthannitrid als Absorbermaterial führt zu größeren Bandbreiten im Vergleich zu Lanthan/Bor, wobei dieser Effekt bei Lanthannitrid als Absorbermaterial besonders stark ausgeprägt ist. Dies lässt sich im Wesentlichen auch für die entsprechenden Systeme mit Bor als Spacermaterial, wie in Figur 7b dargestellt, erkennen. Bei Lanthannitrid als Absorbermaterial und Borkarbid als Spacermaterial erhöht sich zudem die maximale Reflektivität.

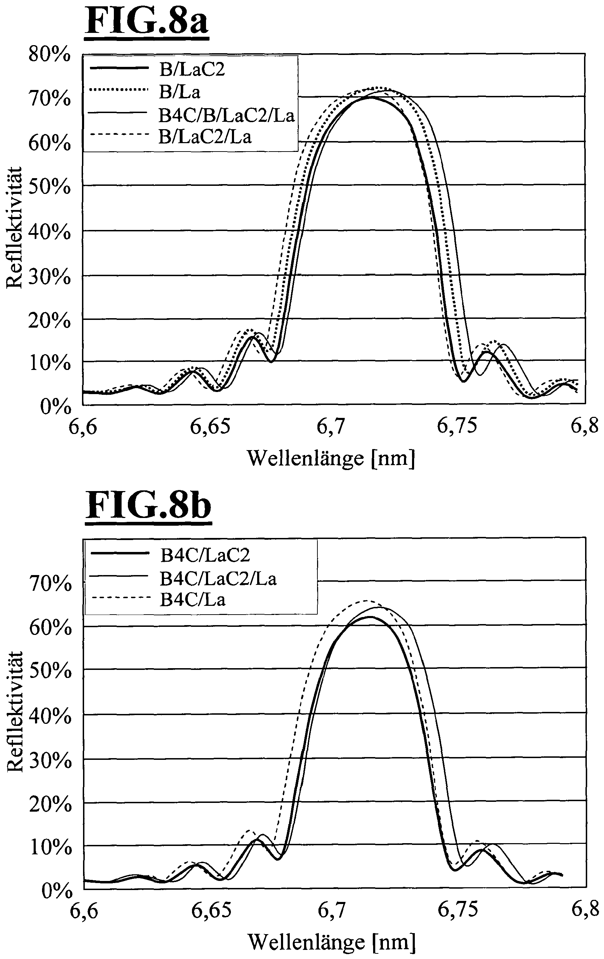

In Figur 8a sind die Reflektivitätskurven für die Systeme Lanthan/Bor alleine oder mit einer oder zwei zusätzlichen Karbidschichten und das System Lanthan/Bor dargestellt. Durch die Karbidschichten wird die Reflektivität nicht merkbar verschlechtert. Allerdings verschiebt sich die Lage der maximalen Reflektivität und damit die Arbeitswellenlänge leicht. Dafür weisen diese Systeme eine erhöhte thermische und thermodynamische Stabilität auf. Bei dem System Lanthankarbid/Bor tritt eine leichte Verschlechterung der Reflektivität ein, die allerdings durch eine längere Lebensdauer wegen einer erhöhten thermodynamischen und thermischen Stabilität ausgeglichen wird.

Für den Fall der in Figur 8b dargestellten Reflektivitätskurven für die Systeme Lanthan/Borkarbid alleine oder mit zusätzlicher Lanthankarbid-Zwischenlage bzw. für das System Lanthankarbid/Borkarbid führen beide Systeme, die Lanthankarbid aufweisen, zu einer etwas verschlechterten Reflektivität. Dies wird aber durch eine längere Lebensdauer kompensiert. Denn über die Zeit und besonders bei erhöhten Temperaturen findet eine geringere Vermischung der einzelnen Lagen miteinander statt als bei Lanthan/Borkarbid.

Ein besonderer Vorteil der hier beschriebenen reflektiven optischen Elemente besteht darin, dass sie sich nicht nur bei Raumtemperatur mit hinreichend langer Lebensdauer betreiben lassen, sondern auch bei Betriebstemperaturen von bis zu 600°C. Auch bei hoher auf die reflektiven optischen Elemente auftreffender Strahlungsintensität ist daher keine Kühlung der reflektiven optischen Elemente notwendig. Selbst der Kollimatorspiegel einer EUV-Lithographievorrichtung, der in der Regel der höchsten Strahlungsintensität ausgesetzt ist, kann ohne Kühlung betrieben werden.

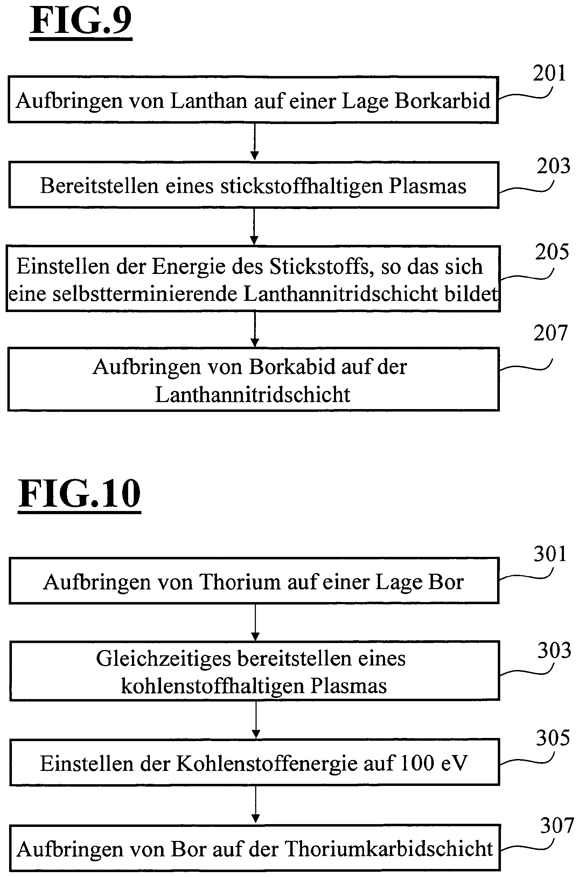

In Figur 9 ist eine erste Ausführungsform des Verfahrens zum Herstellen von reflektiven optischen Elementen mit den hier erläuterten Viellagensysteme am Beispiel eines Lanthan/Borkarbid-Systeme mit Zwischenlage aus Lanthannitrid zur Erhöhung der thermodynamischen und thermischen Stabilität dargestellt. Dazu wird in einem ersten Schritt 201 eine Lage Lanthan auf eine Lage Borkarbid aufgebracht. Zu diesem Zweck können alle bekannten Methoden wie z.B. Sputtern, Aufdampfen u.ä. eingesetzt werden. Anschließend wird ein stickstoffhaltiges Plasma bereitgestellt (Schritt 203). Dazu kann z.B. ein Plasma in einer stickstoffhaltigen Atmosphäre gezündet werden. Dabei wird die Energie des Stickstoffs derart eingestellt, dass sich eine selbstterminierende Lanthannitridschicht bildet (Schritt 205). Die Energie sollte dazu so niedrig liegen, dass die Eindringtiefe der Stickstoffradikale, -moleküle oder -ionen die Dicke einer Monolage Lanthannitrid nicht übersteigt. Eine Mindestenergie ist allerdings vonnöten, damit überhaupt eine Reaktion des Stickstoffs mit dem Lanthan an der Lagenoberfläche zu Lanthannitrid stattfindet. Zum Einstellen der Stickstoffenergie lässt sich die Energiezufuhr zum Plasma ändern oder eventuell auch eine zusätzliche Beschleunigungsspannung anlegen. Als Quellen lassen sich beispielsweise Kaufmann-Quellen, Radiofrequenz-Plasmaquellen oder Zyklotronresonanz-Plasmaquelle einsetzen. Vorteilhafterweise werden Stickstoffradikale, -ionen oder -moleküle eingesetzt, die eine Energie von bis zu 120 eV, bevorzugt bis zu 100 eV, besonders bevorzugt bis zu 80 eV, ganz besonders bevorzugt bis 50 eV aufweisen. Vorteilhafterweise wird die Beschichtungsgeometrie derart gewählt, dass der Auftreffwinkel des Stickstoffs auf die zu beschichtende Oberfläche möglichst flach ist, um zusätzlich die Eindringtiefe zu begrenzen. Idealerweise geht die Teilchenenergie bei der Nitridisierung einer Lage gegen 0 eV. Dies gilt entsprechend, wenn man eine selbstterminierende Karbidschicht mit Kohlenstoffatomen, -radikalen, -ionen oder kohlenstoffhaltigen Molekülen aufbringen möchte. Abschließend wird auf herkömmliche Weise eine Borkarbidlage auf die Lanthannitridlage aufgebracht (Schritt 207). Diese Verfahrensschritte werden entsprechend der gewünschten Stapelanzahl wiederholt.

In Figur 10 ist ein weiteres Ausführungsbeispiel des Herstellungsverfahrens dargestellt: Es wird Thorium auf eine Lage Bor aufgebracht (Schritt 301). Gleichzeitig wird ein kohlenstoffhaltiges Plasma, z.B. mit Hilfe der oben genannten Quellen bereitgestellt (Schritt 303). Der Kohlenstoff kann dabei z.B. über das Einleiten von kohlenstoffhaltigem Gas wie Methan oder Ethan zur Verfügung gestellt werden. Bevorzugt wird Ethin verwendet, um die Wasserstoffkonzentration möglichst gering zu halten. Damit sich eine homogene Thoriumkarbidschicht bildet, ist im vorliegenden Beispiel die Plasmaenergie derart eingestellt, dass der Kohlenstoff ein Energie von etwa 100 eV hat (Schritt 305). Abschließend wird auf herkömmliche Weise eine Borlage auf der Thoriumlage aufgebracht (Schritt 309). Diese Verfahrensschritte werden entsprechend der gewünschten Stapelanzahl wiederholt. Beim Karbidisieren kann in einer Variante zusätzlich oder alternativ zur Plasmabehandlung auch z.B. ein Sputterverfahren eingesetzt werden.

Es sei darauf hingewiesen, dass die hier beschriebenen Ausführungsbeispiele des Herstellungsverfahrens ohne weiteres dahingehend abgewandelt werden können, das jeweils ein anderes Absorbermaterial, ein anderes Spacermaterial oder andere Karbid- oder Nitridschichten verschiedenster Dicken mittels unterschiedlichster Kohlenstoff- oder Stickstoffenergien aufgebracht werden.

Weitere Ausführungsformen der Erfindung sind durch folgende Sätze gegeben, welche als Teil der Beschreibung und nicht als Patentansprüche im Sinne der Entscheidung J 15/88 der juristischen Beschwerdekammer des Europäischen Patentamts anzusehen sind:
1. Reflektives optisches Element für eine Arbeitswellenlänge im Bereich von 5 nm bis 12 nm, das ein Viellagensystem aus mindestens zwei alternierenden Materialien mit unterschiedlichem Realteil des Brechungsindex bei der Arbeitswellenlänge aufweist, dadurch gekennzeichnet, dass an mindestens einem Übergang vom Material (21) mit größerem Realteil des Brechungsindex zum Material (22) mit kleinerem Realteil des Berechungsindex oder vom Material (22) mit kleinerem Realteil des Berechungsindex zum Material (21) mit größerem Realteil des Brechungsindex eine weitere Lage (23) aus einem Nitrid oder Karbid des Material mit kleinerem Realteil des Brechungsindex angeordnet ist.
2. Reflektives optisches Element nach Satz 1, dadurch gekennzeichnet, dass an mindestens einem Übergang vom Material (21) mit größerem Realteil des Brechungsindex zum Material (22) mit kleinerem Realteil des Berechungsindex eine weitere Lage (23) aus einem Nitrid des Material mit kleinerem Realteil angeordnet ist.
3. Reflektives optisches Element nach Satz 1 oder 2, dadurch gekennzeichnet, dass das Material (22) mit kleinerem Realteil des Brechungsindex Lanthan, Thorium oder Uran ist.
4. Reflektives optisches Element nach einem der Sätze 1 bis 3, dadurch gekennzeichnet, dass an mindestens einem Übergang vom Material (22) mit kleinerem Realteil des Brechungsindex zum Material (21) mit größerem Realteil des Berechungsindex eine weitere Lage (24) aus einem Nitrid oder Karbid des Material mit größerem Realteil angeordnet ist.
5. Reflektives optisches Element nach einem der Sätze 1 bis 4, dadurch gekennzeichnet, dass das Material (21) mit größerem Realteil des Brechungsindex Bor oder Borkarbid ist.
6. Reflektives optisches Element nach einem der Sätze 1 bis 5, dadurch gekennzeichnet, dass die Karbid- oder die Nitridlage (23, 24) eine Dicke von bis zu 0,7 nm aufweist.
7. Reflektives optisches Element nach einem der Sätze 1 bis 6, dadurch gekennzeichnet, dass die Karbid- oder die Nitridlage (23, 24) als Monolage ausgebildet ist.
8. Reflektives optisches Element für eine Arbeitswellenlänge im Bereich von 5 nm bis 12 nm, das ein Viellagensystem aus mindestens zwei alternierenden Materialien mit unterschiedlichem Realteil des Brechungsindex bei der Arbeitswellenlänge aufweist, dadurch gekennzeichnet, dass das Material (22') mit kleinerem Realteil des Brechungsindex ein Nitrid oder Karbid ist.
9. Reflektives optisches Element nach Satz 8, dadurch gekennzeichnet, dass das Material (22') mit kleinerem Realteil des Brechungsindex Lanthannitrid, Thoriumnitrid, Lanthankarbid oder Thoriumkarbid ist.
10. Reflektives optisches Element nach Satz 8 oder 9, dadurch gekennzeichnet, dass das Material (21) mit größerem Realteil des Brechungsindex Bor oder Borkarbid ist.
11. Reflektives optisches Element für eine Arbeitswellenlänge im Bereich von 5 nm bis 12 nm, das ein Viellagensystem aus mindestens zwei alternierenden Materialien mit unterschiedlichem Realteil des Brechungsindex bei der Arbeitswellenlänge aufweist, dadurch gekennzeichnet, dass das Material (22) mit kleinerem Realteil des Brechungsindex Thorium, Uran oder Barium ist und dass das Material (21) mit größerem Realteil des Brechungsindex Bor oder Borkarbid ist.
12. Verwendung eines reflektiven optischen Elements nach einem der Sätze 1 bis 11 zur Reflexion von Strahlung im Wellenlängenbereich von 5 nm bis 12 nm bei einer Betriebstemperatur von 20°C bis 600°C.
13. Verwendung eines reflektiven optischen Elements nach einem der Sätze 1 bis 11 als Kollektor von Strahlung im Wellenlängenbereich von 5 nm bis 12 nm in einer EUV-Lithographievorrichtung.
14. Projektionssystem (120), insbesondere für eine EUV-Lithographievorrichtung, mit mindestens einem reflektiven optischen Element (121, 122) gemäß Satz 1 bis 11.
15. Beleuchtungssystem (140), insbesondere für eine EUV-Lithographievorrichtung, mit mindestens einem reflektiven optischen Element (141, 142) gemäß Satz 1 bis 11.
16. Strahlformungssystem (110), insbesondere für eine EUV-Lithographievorrichtung, mit mindestens einem reflektiven optischen Element (112, 113) gemäß Satz 1 bis 11.
17. EUV-Lithographievorrichtung (100) mit mindestens einem reflektiven optischen Element (112, 113, 121, 122, 141, 142) gemäß Satz 1 bis 11.
18. Verfahren zum Herstellen eines reflektiven optischen Elements gemäß Satz 1 bis 11, dadurch gekennzeichnet, dass die Lagen mindestens eines Materials plasmaunterstützt aufgebracht werden.
19. Verfahren nach Satz 18, dadurch gekennzeichnet, dass zunächst eine Lage des Materials mit kleinerem Realteil des Brechungsindex aufgebracht wird, die anschließend einem stickstoff- oder kohlenstoffhaltigen Plasma ausgesetzt wird.
20. Verfahren nach Satz 18, dadurch gekennzeichnet, dass das Aufbringen einer Lage des Materials mit kleinerem Realteil des Brechungsindex zumindest teilweise mit Unterstützung eines stickstoff- oder kohlenstoffhaltigen Plasmas durchgeführt wird.
21. Verfahren nach Satz 19 oder 20, dadurch gekennzeichnet, dass Stickstoff- oder Kohlenstoffatome, -radikale oder -moleküle eingesetzt werden, deren Energie derart eingestellt ist, dass sich eine selbstterminierende Schicht eines Nitrids oder Karbids bildet.
22. Verfahren nach Satz 19 oder 20, dadurch gekennzeichnet, dass Stickstoff- oder Kohlenstoffatome, -radikale oder -moleküle eingesetzt werden, deren Energie derart eingestellt ist, dass sich eine Monolage eines Nitrids oder Karbids bildet.
23. Verfahren nach Satz 19 oder 20, dadurch gekennzeichnet, dass Stickstoff- oder Kohlenstoffatome, -radikale oder -moleküle eingesetzt werden, die eine Energie von bis zu 120eV auf weisen.

### Bezugszeichen

- 1: reflektives optisches Element
- 2: Viellagensystem
- 3: Substrat
- 4: Schutzschicht

- 20: periodisch wiederkehrender Lagenstapel
- 21: Spacer
- 22, 22': Absorber
- 23: Nitrid- oder Karbidschicht
- 24: Nitrid- oder Karbidschicht

- 100: EUV-Lithographievorrichtung
- 110: Strahlformungssystem
- 111: Strahlungsquelle
- 112: Kollektorspiegel
- 113: Monochromator
- 120: Beleuchtungssystem
- 121, 122: Spiegel
- 130: Photomaske
- 140: Projektionssystem
- 141,142: Spiegel
- 150: Wafer

- 201 - 207: Verfahrensschritte
- 301 - 307: Verfahrensschritte

## Patentansprüche

1. Reflektives optisches Element für eine Arbeitswellenlänge im Bereich von 5 nm bis 12 nm, das ein Viellagensystem aus mindestens zwei alternierenden Materialien mit unterschiedlichem Realteil des Brechungsindex bei der Arbeitswellenlänge aufweist, **dadurch gekennzeichnet, dass** an mindestens einem Übergang vom Material (21) mit größerem Realteil des Brechungsindex zum Material (22) mit kleinerem Realteil des Berechungsindex oder vom Material (22) mit kleinerem Realteil des Berechungsindex zum Material (21) mit größerem Realteil des Brechungsindex eine weitere Lage (23) aus einem Nitrid oder Karbid des Material mit kleinerem Realteil des Brechungsindex angeordnet ist, wobei das Material (22) mit kleinerem Realteil des Brechungsindex Lanthan, Thorium oder Uran ist.

2. Reflektives optisches Element nach Anspruch 1, **dadurch gekennzeichnet, dass** an mindestens einem Übergang vom Material (21) mit größerem Realteil des Brechungsindex zum Material (22) mit kleinerem Realteil des Berechungsindex eine weitere Lage (23) aus einem Nitrid des Material mit kleinerem Realteil angeordnet ist.

3. Reflektives optisches Element nach Anspruch 1 oder 2, **dadurch gekennzeichnet, dass** an mindestens einem Übergang vom Material (22) mit kleinerem Realteil des Brechungsindex zum Material (21) mit größerem Realteil des Berechungsindex eine weitere Lage (24) aus einem Nitrid oder Karbid des Material mit größerem Realteil angeordnet ist.

4. Reflektives optisches Element nach einem der Ansprüche 1 bis 3, **dadurch gekennzeichnet, dass** das Material (21) mit größerem Realteil des Brechungsindex Bor oder Borkarbid ist.

5. Reflektives optisches Element nach einem der Ansprüche 1 bis 4, **dadurch gekennzeichnet, dass** die Karbid- oder die Nitridlage (23, 24) eine Dicke von bis zu 0,7 nm aufweist.

6. Reflektives optisches Element nach einem der Ansprüche 1 bis 5, **dadurch gekennzeichnet, dass** die Karbid- oder die Nitridlage (23, 24) als Monolage ausgebildet ist.

7. Reflektives optisches Element für eine Arbeitswellenlänge im Bereich von 5 nm bis 12 nm, das ein Viellagensystem aus mindestens zwei alternierenden Materialien mit unterschiedlichem Realteil des Brechungsindex bei der Arbeitswellenlänge aufweist, **dadurch gekennzeichnet, dass** das Material (22') mit kleinerem Realteil des Brechungsindex ein Nitrid oder Karbid ist, wobei das Material (22') mit kleinerem Realteil des Brechungsindex Lanthannitrid, Thoriumnitrid, Lanthankarbid oder Thoriumkarbid ist.

8. Reflektives optisches Element nach Anspruch 7, **dadurch gekennzeichnet, dass** das Material (21) mit größerem Realteil des Brechungsindex Bor oder Borkarbid ist.

9. Projektionssystem (120), insbesondere für eine EUV-Lithographievorrichtung, mit mindestens einem reflektiven optischen Element (121, 122) gemäß Anspruch 1 bis 8.

10. Beleuchtungssystem (140), insbesondere für eine EUV-Lithographievorrichtung, mit mindestens einem reflektiven optischen Element (141, 142) gemäß Anspruch 1 bis 8.

11. Strahlformungssystem (110), insbesondere für eine EUV-Lithographievorrichtung, mit mindestens einem reflektiven optischen Element (112, 113) gemäß Anspruch 1 bis 8.

12. EUV-Lithographievorrichtung (100) mit mindestens einem reflektiven optischen Element (112, 113, 121, 122, 141, 142) gemäß Anspruch 1 bis 8.

## Claims

1. Reflective optical element for a working wavelength in the range of 5 nm to 12 nm, having a multilayer system made of at least two alternating materials having different real parts of the refractive index at the operating wavelength, wherein, at at least a transition from the material (21) having the greater real part of the refractive index to the material (22) having the smaller real part of the refractive index, or from the material (22) having the smaller real part of the refractive index to the material (21) having the greater real part of the refractive index, a further layer (23) made of a nitride or carbide of the material having the smaller real part of the refractive index is arranged, wherein the material (22) having the smaller real part of the refractive index is lanthanum, thorium or uranium.

2. Reflective optical element according to Claim 1, **characterized in that**, at at least a transition from the material (21) having the greater real part of the refractive index to the material (22) having the smaller real part of the refractive index, a further layer (23) made of a nitride of the material having the smaller real part is arranged.

3. Reflective optical element according to Claim 1 or 2, **characterized in that**, at at least a transition from the material (22) having the smaller real part of the refractive index to the material (21) having the greater real part of the refractive index, a further layer (24) made of a nitride or carbide of the material having the greater real part is arranged.

4. Reflective optical element according to one of Claims 1 to 3, **characterized in that** the material (21) having the greater real part of the refractive index is boron or boron carbide.

5. Reflective optical element according to one of Claims 1 to 4, **characterized in that** the carbide or nitride layer (23, 24) has a thickness of up to 0.7 nm.

6. Reflective optical element according to one of Claims 1 to 5, **characterized in that** the carbide or nitride layer (23, 24) is in the form of a monolayer.

7. Reflective optical element for a working wavelength in the range of 5 nm to 12 nm, having a multilayer system made of at least two alternating materials having different real parts of the refractive index at the working wavelength, wherein the material (22') having the smaller real part of the refractive index is a nitride or carbide, wherein the material (22') having the smaller real part of the refractive index is lanthanum nitride, thorium nitride, lanthanum carbide or thorium carbide.

8. Reflective optical element according to Claim 7, **characterized in that** the material (21) having the greater real part of the refractive index is boron or boron carbide.

9. Projection system (120) in particular for an EUV lithography apparatus, having at least one reflective optical element (121, 122) according to Claim 1 to 8.

10. Illumination system (140), in particular for an EUV lithography apparatus, having at least one reflective optical element (141, 142) according to Claim 1 to 8.

11. Beamshaping system (110), in particular for an EUV lithography apparatus, having at least one reflective optical element (112, 113) according to Claim 1 to 8.

12. EUV lithography apparatus (100) having at least one reflective optical element (112, 113, 121, 122, 141, 142) according to Claim 1 to 8.

## Revendications

1. Élément optique réfléchissant pour une longueur d'onde de travail dans la plage de 5 nm à 12 nm, lequel possède un système multicouches composé d'au moins deux matériaux alternés ayant des parties réelles différentes de l'indice de réfraction à la longueur d'onde de travail, une couche supplémentaire (23) en un nitrure ou un carbure du matériau ayant la partie réelle la plus petite de l'indice de réfraction étant disposée au niveau d'au moins une transition du matériau (21) ayant la partie réelle la plus grande de l'indice de réfraction vers le matériau (22) ayant la partie réelle la plus petite de l'indice de réfraction ou du matériau (22) ayant la partie réelle la plus petite de l'indice de réfraction vers le matériau (21) ayant la partie réelle la plus grande de l'indice de réfraction, le matériau (22) ayant la partie réelle la plus petite de l'indice de réfraction étant du lanthane, du thorium ou de l'urane.

2. Élément optique réfléchissant selon la revendication 1, **caractérisé en ce qu'**une couche supplémentaire (23) en un nitrure du matériau ayant la partie réelle la plus petite est disposée au niveau d'au moins une transition du matériau (21) ayant la partie réelle la plus grande de l'indice de réfraction vers le matériau (22) ayant la partie réelle la plus petite de l'indice de réfraction.

3. Élément optique réfléchissant selon la revendication 1 ou 2, **caractérisé en ce qu'**une couche supplémentaire (24) en un nitrure ou un carbure du matériau ayant la partie réelle la plus grande est disposée au niveau d'au moins une transition du matériau (22) ayant la partie réelle la plus petite de l'indice de réfraction vers le matériau (21) ayant la partie réelle la plus grande de l'indice de réfraction.

4. Élément optique réfléchissant selon l'une des revendications 1 à 3, **caractérisé en ce que** le matériau (21) ayant la partie réelle la plus grande de l'indice de réfraction est du bore ou du carbure de bore.

5. Élément optique réfléchissant selon l'une des revendications 1 à 4, **caractérisé en ce que** la couche de carbure ou de nitrure (23, 24) possède une épaisseur maximale de 0,7 nm.

6. Élément optique réfléchissant selon l'une des revendications 1 à 5, **caractérisé en ce que** la couche de carbure ou de nitrure (23, 24) est réalisée sous la forme d'une monocouche.

7. Élément optique réfléchissant pour une longueur d'onde de travail dans la plage de 5 nm à 12 nm, lequel possède un système multicouches composé d'au moins deux matériaux alternés ayant des parties réelles différentes de l'indice de réfraction à la longueur d'onde de travail, le matériau (22') ayant la partie réelle la plus petite de l'indice de réfraction étant un nitrure ou un carbure, le matériau (22') ayant la partie réelle la plus petite de l'indice de réfraction étant du nitrure de lanthane, du nitrure de thorium, du carbure de lanthane ou du carbure de thorium.

8. Élément optique réfléchissant selon la revendication 7, **caractérisé en ce que** le matériau (21) ayant la partie réelle la plus grande de l'indice de réfraction est du bore ou du carbure de bore.

9. Système de projection (120), notamment pour un dispositif de lithographie EUV, comprenant au moins un élément optique réfléchissant (121, 122) selon l'une des revendications 1 à 8.

10. Système d'éclairage (140), notamment pour un dispositif de lithographie EUV, comprenant au moins un élément optique réfléchissant (141, 142) selon l'une des revendications 1 à 8.

11. Système de mise en forme de faisceau (110), notamment pour un dispositif de lithographie EUV, comprenant au moins un élément optique réfléchissant (112, 113) selon l'une des revendications 1 à 8.

12. Dispositif de lithographie EUV (100) comprenant au moins un élément optique réfléchissant (112, 113, 121, 122, 141, 142) selon l'une des revendications 1 à 8.
